# EUROPEAN PATENT APPLICATION

(11) **EP 0 840 453 A2**
(43) Date of publication of application: **06.05.1998**
(21) Application number: 97118708.3
(22) Date of filing: 28.10.1997
(51) Int. Cl.: H03K 19/003

(54) **An output buffer**

(30) Priority: 28.10.1996 US 741423
(71) Applicant: TEXAS INSTRUMENTS INCORPORATED, Dallas Texas 75265 (US)
(72) Inventor: Blake, Terence G. W., Dallas, Texas 75230 (US); Andresen, Bernhard, Dallas, Texas 75238 (US)
(74) Representative: Schwepfinger, Karl-Heinz, Dipl.-Ing.

(57) **Abstract**

An output buffer includes a pair of P-channel transistors and two cascode pull-down N-channel transistors to drive an output node. The output pull-up transistor (Q6) has the gate thereof connected through a P-channel control transistor (Q5) to an input driving signal. The control signal is isolated from the output node by a shunt P-channel transistor (Q4) which only conducts during overvoltage conditions. During normal operation, the control transistor (Q5) is maintained in a conductive state to allow the gate of the output pull-up transistor (Q6) to be pulled high and low. During an overvoltage condition, the shunt P-channel transistor (Q4) connected between the output node and the control transistor is turned on to effectively turn off the control transistor. The output P-channel transistor (Q6) is protected from excess voltages across the gate oxide when initially coming out of the hiZ state with a logic high signal on the input. This is facilitated by pulling the gate thereof low to a voltage above ground and then pulling the gate fully to ground when the voltage on the output node falls to below the supply voltage. This is provided by a NAND gate structure (120,122,124,128) that disposes a limiting P-channel transistor (128) in series with the gate of the P-channel pull-up transistor (Q6) to prevent it from going to a full logic low level. When the voltage on the output is pulled down by the shunt P-channel transistor (Q4), this will then bypass the limiting P-channel transistor (128) in the NAND gate and pull the gate of the P-channel pull-up transistor (Q6) down to the full low logic level.

## Description

### TECHNICAL FIELD OF THE INVENTION

The present invention pertains in general to output buffer circuits and, more particularly, to an output buffer circuit that tolerates an overvoltage condition on the output thereof.

### BACKGROUND OF THE INVENTION

As semiconductor integrated circuits (Ics) have increased in density, the power supply voltage levels provided thereto have been correspondently decreased to reduce the deleterious effects of voltage differentials across increasingly smaller device dimensions. In the early days of semiconductor devices, the voltage levels were approximately +/- 12 volts. In the mid 1970s, the voltage level was reduced to 5 volts with only a single voltage level required. A recent change is that from a nominal 5 volt value to a 3.3 volt value. However, this change in voltage has not occurred on all parts, such that the semiconductor parts are now mixed and, therefore, there is a requirement for 3.3 volt devices to communicate with 5.0 volt devices. This therefore requires a chip designer to accommodate a level on an output pin higher than the operating voltage, i.e. a 3.3. volt part must be able to tolerate a 5.0 volt level. This is even further exacerbated in situations such as a PCI bus, wherein the voltage can even rise up to a single diode drop above the 5.0 volt level.

One of the problems that exists when operating a 3.3 volt part in a 5.0 volt environment is that the transistors in the 3.3 volt part are designed with gate oxide layers that will not tolerate a full 5.0 volt level between the inversion layer and gate. Therefore, a conventional output driver consisting of a pull-up P-channel transistor in series with the N-channel pull-down transistor and connecting the gate thereof to the V_{DD}. Another problem is with respect to the N-well in which the P-channel transistors are typically fabricated. The well itself is typically tied to V_{DD} which, when operating under a 3.3 volt output limit, is sufficient. Whenever the voltage rises above that level, the source/drain-to-well PN junction will be forwarded biased and current will be drawn from the output pad to the 3.3 volt supply pad. This has typically been solved by having a "floating well", which is switched between the 3.3 volt level and the 5.0 volt level, depending upon the output voltage on the output pad.

A third problem that exists is that, during a hiZ condition in a three-state operation, the P-channel pull-up transistor can turn "ON" whenever the output voltage goes to 5.0 volts. This problem was described in U.S.Patent No 5,160,855, issued to *Dobberpuhl* on November 3, 1992. The buffer described in *Dobberpuhl* utilized circuitry for insuring that the P-channel pull-up transistor was not turned "ON" whenever the output voltage exceeded the 3.3 volt power supply level. However, the circuit of *Dobberpuhl* did not completely maintain the P-channel pull up transistor "OFF" in all conditions and, therefore, there remained certain conditions that would result in current spikes and leakage currents, raising the power level of the circuit.

An additional problem that exists is when the circuit comes out of the hiZ condition and the output is to be driven high and a voltage greater than 3.3 volts is present on the output. In this condition, the P-channel pull-up transistor will have the gate thereof pulled low and this could result in the P-channel pull-up having greater than V_{DD} disposed across the gate oxide.

### SUMMARY OF THE INVENTION

The present invention disclosed herein comprises a three-state output buffer that operates in a high impedance state to present a high impedance on an output terminal and in a normal low impedance state to receive a logic input on an input terminal and then to drive the output terminal to a corresponding logic state. The output buffer has associated therewith an output P-channel pull-up transistor connected between the output terminal and a power supply node. It includes a protection circuit for protecting the gate oxide of the output P-channel pull-up transistor. This protection circuit includes a driving device for turning "ON" the output P-channel pull-up transistor when the operating mode of the output buffer changes from a high impedance state to a low impedance state, and the input logic state is such that the output of the buffer will be pulled high by the output P-channel pull-up transistor in the low impedance state. A limiting device is provided for limiting the maximum voltage across the gate oxide of the P-channel pull-up transistor to a first predetermined voltage. This will allow for excessive voltages to be disposed on the output that will exceed the first predetermined voltage. Under these conditions, the voltage across the gate oxide of the output P-channel pull-up transistor will not exceed the first predetermined voltage and damage the gate oxide of the output P-channel pull-up transistor.

In another aspect of the present invention, the limiting device includes a conditional pull-down circuit for conditionally pulling the gate of the output P-channel pull-up transistor down to a voltage level that is less than the voltage on the output terminal by a value equal to or less than the first predetermined voltage. A pull-down device then pulls the gate of the output P-channel pull-up transistor to the low logic level when the voltage of the output is less than or equal to the first predetermined voltage.

### BRIEF DESCRIPTION OF THE DRAWINGS

For a more complete understanding of the present invention and the advantages thereof, reference is now made to the following description taken in conjunction with the accompanying Drawings in which:
Figure 1 illustrates a prior art output buffer circuit;
Figure 2 illustrates one embodiment of an output buffer circuit to provide for over voltage conditions on the output;
Figure 3 illustrates an alternate embodiment of the output buffer of Figure 3, this being the preferred embodiment; and
Figure 4 illustrates a cross sectional diagram of a floating N-well transistor.

### DETAILED DESCRIPTION OF THE INVENTION

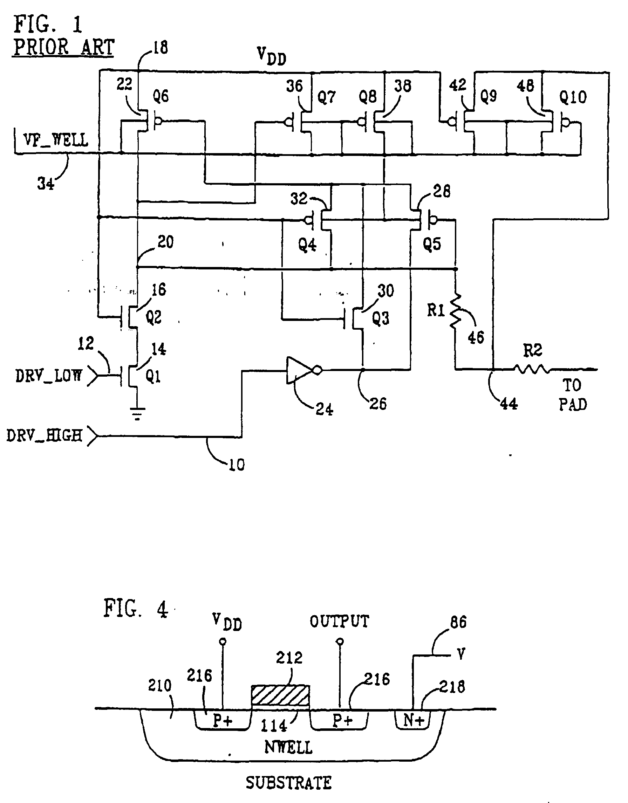

Referring now to Figure 1, there is illustrated a prior art output buffer circuit, which incorporates the teachings of U.S. Patent No. 5,160,855 issued to Dobberpuhl. The output buffer receives two inputs, a high input drive signal on a line 10 labeled DRV_HIGH and a low driving signal on a line 12, labeled DRV_LOW. Only one of these driving signals can be high at any given time during normal operation, although both may be low together. The low driving signal drives an N-channel transistor 16, labeled "Q2". The gate of transistor 16 is connected to a power supply node 18 labeled V_{DD}. In the examples utilized herein, V_{DD} is approximately 3.3V ± 0.3V, with the pad voltage being 0.0 volts to 5.0V ± 0.5V. The transistor 16 is in a cascode configuration with the N-channel transistor 14. The other side of the source/drain path of transistor 16 is connected to an output node 20, output node 20 connected to one side of the source/drain path of a pull-up P-channel transistor 22 labeled "Q6". The other side of the source/drain path of transistor 22 is connected to the power supply node 18.

The driving signal for the gate of the pull-up transistor 22 is provided by the high driving signal on line 10. This signal is input through an inverter 24 to a node 26, node 26 connected to one side of the source/drain path of a P-channel transistor 28, the other side thereof connected to the gate of pull-up transistor 22 on node 23. Transistor 28 is labeled "Q5". The gate of transistor 28 is connected to output node 20. Transistor 28 has disposed in parallel therewith the source/drain path of an N-channel transistor 30 having the gate thereof connected to the power supply node and labeled "Q3". A P-channel transistor 32 has the source/drain path thereof connected between the gate of transistor 22 and the output node 20, and is labeled "Q4".

It can be seen that whenever the system is in a normal operating mode and the high driving signal is low and the low driving signal is high, this turns "ON" transistor 14, pulling node 20 down, which turns "ON" transistor 28. When transistor 28 is turned "ON" the gate of transistor 22 will be pulled high, turning transistor 22 "OFF". In the opposite logic state, the low driving signal on line 12 will go low turning "OFF" transistor 14 and the high driving signal on line 10 will go high, pulling node 26 low to turn "ON" transistor 22.

In operation, if the output voltage on node is less than V_{DD}, then transistor 32 is cut off and the voltage on node 26 constitutes the gate voltage on transistor 22. However, if the output voltage is greater than V_{DD}, then transistor 32 will conduct and the voltage on the gate of transistor 22 will be the voltage on node 20. When the voltage on node 26 is low, transistor 30 is conducting and the gate of transistor 22 will be brought low to 0.0 volts. This will cause the output voltage on node 20 to go to V_{DD} and, therefore, transistors 28 and 32 will be "OFF". Alternatively, when node 26 is high and the driving signal on line 12 is low, the output may be disposed at any voltage from 0.0 voltage to 5.0 volts, depending on the conditions external to the output driver stage. This latter node is the third operating state of the output buffer, the hiZ condition.

Each of the P-channel transistors 22, 28 and 32 are "floating well" transistors, which have the well thereof connected to a floating well voltage node 34. A P-channel transistor 36 and the P-channel transistor 38 each have the source/drain paths thereof connected between the power supply node 18 and the floating well node 34. The gate of transistor 38 is connected to the floating well node 34 and the gate of transistor 36 is connected to the output node 20. Therefore, whenever the output node 20 is pulled low, the voltage V_{DD} will be connected to the floating well node 34. Whenever the output voltage is above V_{DD}, transistor 36 will be turned "OFF". Transistors 36 and 38 are labeled "Q7" and "Q8" respectively.

A P-channel transistor 42 labeled "Q9" has the source/drain path thereof connected between a node 44 and the floating well voltage node 34. Node 44 is connected to one side of a resistor 46 which is labeled "R1". The other side of R1 connects to node 20. The gate of transistor 42 is connected to the V_{DD} voltage level. The well of transistor 42 is connected to the floating well voltage node 24. A P-channel transistor 48 has the source/drain path thereof connected between node 44 and the floating well node 34 and the gate thereof connected to the floating well node 34. The transistor 48 is a floating well transistor with the floating well thereof connected to the floating well voltage node 34. At the same time, transistor 36 will be turned "OFF" and transistor 38 will be turned "OFF".

In the situation where a hiZ signal is present (DRV-LOW and DRV-HIGH are both low), and the current state of the output is V_{DD} i.e. transistor 22 was previously "ON", all of the floating well switch transistors 36, 38, 42 and 48 will be turned "OFF". This is an undesirable condition due to the fact that well leakage could pull the output down far enough to forward bias the well-pmoat junctions. When this happens, h_{FE} multiplied by the leakage current will be dumped into the substrate through the pmoat (emitter)/well(base)/substrate(collector) parasitic transistors. The second problem that exists with the output buffer of Figure 1 is turning "OFF" the output transistor 22. The gate of the output of transistor 22 in normal operation is controlled by the DRV-HIGH signal coupled through the transmission gate comprised of the transistors 28 and 30. The transistor 32 controls the gate when the pad is at 5 volts, which can only happen in the hiZ state. In the condition where the output is hiZ, and the level is 3.0 volts on the output of 20, then transistor 30, transistor 32 and transistor 28 are all "OFF". This will allow the gate of transistor 22 to "float". With nothing to hold it high, the gate voltage of transistor 22 could droop to where it would conduct a sufficient amount to increase the output leakage current from the power supply node 18 to the output node 20. Additionally, under the condition of an output logic "1" to logic "0" transition in normal operation, transistor 28 will shut be "OFF" until the output approaches the logic "0" state and transistor 30 cannot fully turn "OFF" transistor 22. This slows down how fast transistor 22 will turn "OFF", which increases the power supply current spikes which, in turn, increase the switching noise.

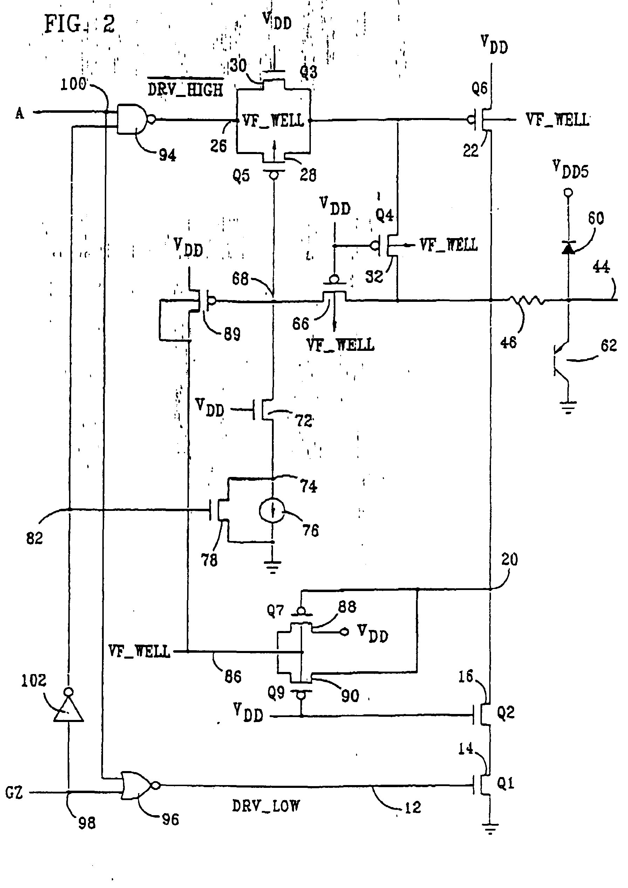

Referring now to Figure 2, there is illustrated a schematic diagram of a three-state output buffer addressing some of the problems noted above with respect to the output buffer of Figure 1. Like parts between Figure 1 and Figure 2 utilize the same reference numerals and the same designations. For example, transistors 14 and 16 are the same and are disposed between the output node 20 and ground. The pull-up transistor 22 is connected between the node 20 and V_{DD}, with the gate thereof connected to one side of the source/drain path of the two parallel connected transistors 28 and 30, the other side thereof connected to the node 26. The transistor 32 labeled "Q4" is connected between the gate of transistor 22 and the output node 20. The gate of transistor 32 is connected to V_{DD}. The resistor 46 is connected between the node 20 and the node 44, with an electrostatic protection device (ESD) disposed on the node 44. A SCR has the cathode thereof connected to node 44 and the cathode thereof connected to ground.

One primary difference between the prior art structure and the embodiment of Figure 2 us the inclusion of a P-channel transistor 66 having the source/drain path thereof connected between the node 20 and a node 68, with the gate of transistor 66 connected to V_{DD}. As such, transistor 66 now isolates the gate of transistor 28 from the node 20. The node 68 is connected to one side of the source/drain path of an N-channel transistor 72, the other side thereof connected to a node 74, the gate of transistor 72 connected to V_{DD}. Node 74 is connected to one side of a current source 76, the other side thereof connected to ground. Node 74 is also connected to one side of the source/drain path of an N-channel transistor 78, the other side thereof connected to ground. The gate of N-channel transistor 78 is connected to a node 82. The node 68 also drives the gate of the P-channel transistor 89, the source/drain path thereof connected between V_{DD} and a floating well voltage node 86, similar to the floating well voltage node 34 of Figure 1. The P-channel transistors 22,28,32,66,89,36 and 42 all have the wells thereof connected to the node 86.

The node 86 is a switched node with is either connected to the output node 20 or to V_{DD}. This is facilitated with a P-channel transistor 88 having the source/drain path thereof connected between V_{DD} and the node 86 and the gate thereof connected to the node 20, the N-well thereof connected to the N-well voltage node 86. A P-channel transistor 90 has the source/drain path thereof connected between the output node 20 and the N-well voltage node 86, the gate thereof connected to V_{DD} and the well thereof connected to the N-well voltage node 86.

The drive signals are derived from a logic circuit which is comprised of a NAND gate 94 and a NOR gate 96. The NOR gate 96 and one input thereof connected to an input node 98 having a signal GZ disposed thereon and the other input thereof connected to a node 100 having the signal "A" disposed thereon, the input driving signal. The NAND gate 94 has one input thereof connected to the node 100 and one input thereof connected to node 82, node 82 connected to the output of an inverter 102, the input thereof connected to the node 98. In a normal operational state, the signal GZ is low, such that the output of NOR gate 96 is controlled by the signal on line 100 and the node 82 will be high, such that the output node 20 being in phase with this logic state, this being a conventional operation. During a hiZ operation, the signal on node 98 is raised high, forcing the output of NOR gate 96 low, turning "OFF" transistor 14 and forcing the output of NAND gate 94 high on node 26, turning "OFF" transistor 22. Node 82 also controls transistor 78, such that the normal operational mode will have transistor 78 conducting and it will not conduct in the hiZ state. In this state, the current source 76 will draw current from node 74.

When the buffer is active, the transistor 78 pulls the gate of transistor 28 on node 68 low through transistor 72. Transistor 72 is utilized as a protection device to reduce the stress on transistor 78. This is achieved similar to the manner in which transistor 16 protects transistor 14, i.e. the maximum voltage that can be disposed across transistor 72 is the difference between V_{DD} and the voltage on node 20., whereas the gate of transistor 78 being pulled low does not see the same voltage on node 74, since node 74 must be one threshold voltage below V_{DD}. By maintaining node 68 low, when the voltage on node 26 is high, this will insure that the voltage on the gate of transistor 22 will not "droop", as was the case with the output buffer of Figure 1. It therefore eliminates the output leakage current and through current spikes that existed in the prior art buffer wherein transistor 28 shuts "OFF" when both nodes 26 and 20 were in logic "1" states.

The transistor 89 operates to insure that, even though node 20 is disposed at a logic "1", i.e. 3;3 volts, the well is clamped high to V_{DD}. This is due to the fact that node 68 is pulled low with transistor 66 turned "OFF". The prior art system of Figure 1 would allow transistor 36 (Q7) to turn "OFF" when the node 20 was high. By ensuring that the wells of the P-channel transistors are connected to V_{DD} for all voltage levels between ground and V_{DD}, the present invention eliminates substrate leakage current.

When the output goes into a hiZ state, transistor 78 is turned "OFF", but current source 76 maintains current flow through node 74 to ground and through transistor 72. The current source 76 is basically fabricated from a long channel NMOS device, such that the current approaches zero as the drain-to-source voltage goes to zero. No static current is drawn as long as the voltage on node 29 is between V_{DD} and ground. When the voltage on node 20 goes above V_{DD}, transistor 66 turns "ON" shutting "OFF" transistor 89 and transistor 28 by pulling their gate voltages to the voltage on node 20. However, current continues to be drawn through current source 76 from the node 20, the value of which is I1. This current is specified, in one embodiment, at 85 µ A maximum.

The three primary distinctions between the embodiment of Figure 2 and the prior art is, first, that transistor 28 is maintained in an active state when the output buffer is in a hiZ state and V_{DD} is applied to the output node. This ensures that transistor 22, the driving transistor, is turned "OFF" to prevent any leakage current during the hiZ state. Second, the transistor 89 is added such that, when the output node is at 3.3 volts, a logic "1", "the N-well bias is maintained at a definite voltage, unlike the prior art which maintains it at a definite voltage only when the output is an 5.0 volts or 0.0 volts. Third, since the transistor 28 is always in an active state, instead of having its gate tied to the output node 20, the current spike between a logic "1" to a logic "0" transition is reduced. This is due to the fact that, when transistor 22 has its gate disposed at ground, if the NAND gate 94, which is a P-channel pre-driver, pulls the node 26 from a low to a high. Since transistor 66 is present and the gate of transistor 28 is not connected directly to node 20, transistor 28 is not "OFF" when the output on node 20 is high. As described above, if this were the case and the gate of transistor 28 were connected to node 20, this would require the N-channel transistors 14 and 16 to pull the node 20 low enough to turn "ON" the transistor 28 with the gate connected to node 20 (the prior art system of Figure 1) a sufficient amount before the gate of transistor 22 could be pulled high. During this period of time that node 20 is being pulled low to turn "ON" transistor 28 (prior art of Figure 1), current will be drawn through transistor 22.

In the embodiment of Figure 2, one problem that is not solved by the circuitry disclosed thereon is the condition wherein the signal level of A on node 100 is high when the system comes out of the hiZ state, i.e. when GZ goes from a high to a low. Since this is a non-inverting buffer, a high signal level on node 100 during the operational mode will result in a high signal level on the output. This high signal level is a result of the P-channel transistor 2 pulling up the output node 44. I order to do this, the gate thereof must be pulled low. Therefore, the NAND gate must pull the gate of transistor 22 low through N-channel transistor 30. However, if the NAND gate 94 pulls the transistor 22 low at a high rate, it is possible that the voltage on the output node 44 will not "relax" to a sufficient level prior to the gate of transistor 22 being pulled to ground, such that a voltage large than V_{DD} may be imposed across the gate oxide of transistor 22, thereby overstressing the transistor 22. This over voltage condition can be disposed thereon as a result of another chip external to the output buffer pulling the node high during the hiZ state such that when the bus is released, the bus is charged up to a high voltage level. During this condition, this voltage level must be discharged prior to transistor 22 turning "ON". Alternatively, there may be an error in the system where another part is inadvertently pulling the bus high. In any event, an over voltage condition present when the output buffer of Figure 2 comes out of hiZ state wit the high signal low on the data input can result in undue stress on transistor 22.

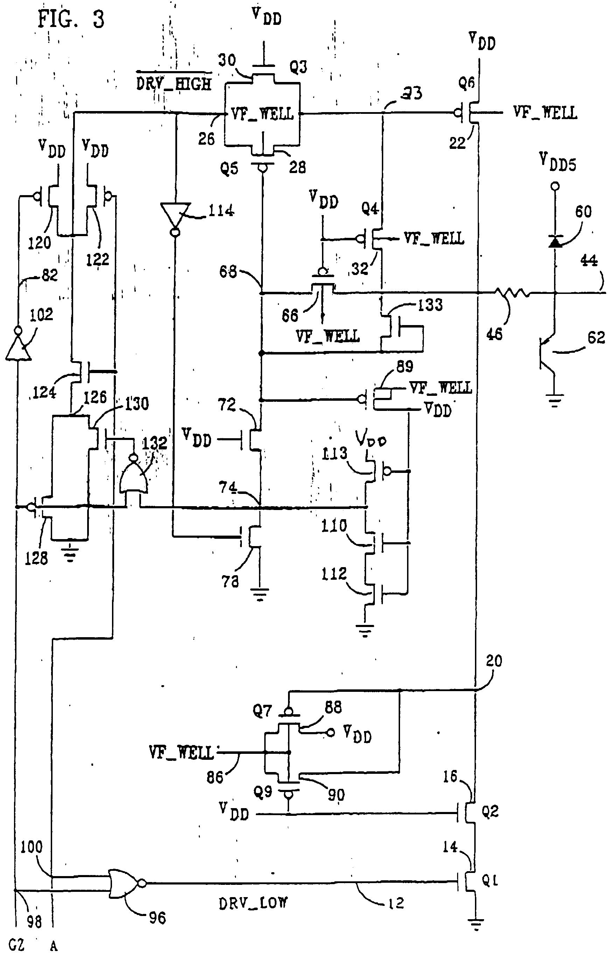

Referring now to Figure 3, there is illustrated an alternative embodiment of the output buffer of Figure 2, this alternate embodiment being the preferred embodiment. In Figure 2, the current source 76 of Figure 2 is represented by two N-channel transistors 110 and 112, which are connected in a series configuration with the source/drain paths thereof connected together and between node 74 and ground, and the gates thereof connected together and to V_{DD}. A P-channel transistor 113 has the source/drain path thereof connected between node 74 and V_{DD} and the gate thereof connected to VDD. The N-channel transistor 78, having the source/drain path thereof connected between node 74 and ground, has its gate connected to the output of an inverter 114, the input thereof connected to the node 26, Inverter 114 is a feedback inverter having the threshold thereof adjusted such that V_{DD}/2 is much greater than the threshold voltage. This is facilitated by sizing the P-channel and N-channel output transistors in such a manner that the P-channel transistors are smaller transistors. In this example, the P-channel transistors have width of 8 microns and the N-channel transistors have a width of 30 microns. The operation of this will be described hereinbelow.

The NAND gate 94 from Figure 2 is also modified in this embodiment. The NAND gate embodied in the buffer of Figure 3 has symmetrical P-channel transistors 120 and 122, both having the source/drain paths thereof connected between V_{DD} and node 26. The gate of transistor 120 is connected to node 82 for receiving the inverted GZ signal, and the gate of transistor 122 is connected to the node 100 to receiving the input data signal A. An N-channel transistor 124 has the source/drain path thereof connected between the node 26 and a node 126. A P-channel transistor 128 has the source/drain path thereof connected between node 126 and ground and the gate thereof connected to node 98. An N-channel transistor 130 has the source/drain path thereof connected between node 126 and ground and the gate thereof connected to the output of a NOR gate 132. NOR gate 132 has one input thereof connected to node 98 and the other input thereof connected to node 74.

The operation of the output buffer of Figure 3 will now be described in detail with respect to the condition wherein the output buffer is moved from a hiZ state to an operational state with the signal level on node 100 being in a high logic state, such that the output P-channel transistor 22 will, in the operational mode, pull the output node 20 high. The P-channel transistor 128 is configures as a source follower such that node 26 can be pulled down as soon as GZ goes low. However, the P-channel transistor 128 can only pull node 126 down to within a threshold voltage of ground, which threshold voltage can be as high as 1.0 volt, due to the body effect of transistor 128. Alternatively, a stack of P-channel transistors could be utilized in place of transistor 128 to increase this voltage level, if necessary. Node 26 would not be pulled entirely to the ground. Also, the load on node 44 will slow the descent of nodes 26 and 20. The voltage on the gate of transistor 22 will follow node 26 and turn "ON" the output P-channel transistor 22. However, the voltage across the gate oxide of transistor 22 is kept within the tolerance level thereof, as will be described herein below. The low threshold of inverter 114 will cause its output to remain low and transistor 78 turned "OFF" until the voltage on node 20 has dropped low enough for transistor 66 to turn "OFF" and for transistors 110 and 112 to discharge node 74 to ground.

When the voltage on node 74 goes low, it will cause the output of NOR gate 132 to go high turning "ON" transistor 130, this in turn pulling node 126 and node 26 to ground, and that action will switch the inverter 114 when it falls below the threshold thereof, which as described above, is much less than V_{DD}/2. This will cause transistor 78 to turn "ON" holding node 74 low.

When the output voltage on node 44 is more than one threshold above V_{DD}, with transistor 128 being "OFF" transistor 32 will turn "ON", thus providing a discharge path from node 20, through transistor 32 to node 26 and also preventing output transistor 22 from turning "ON". When P-channel transistor 128 is first turned "ON", node 26 is pulled down, pulling node 20 down through transistor 32 in series with transistor 30, and through transistor 22 discharging into VDD. However, when node 20 falls below one threshold above the gate of transistor 32, i.e. V_{DD}, transistor 32 will begin to turn "OFF". This will allow the voltage on node 20 to remain one threshold voltage above V_{DD}, if nothing else were provided. However, node 26 is only pulled to no less than one threshold voltage above ground and, therefore, the maximum voltage at this point across the gate oxide of transistor 22 is V_{DD}. As transistor 66 shuts "OFF", nodes 26,68 and 74 are pulled low by N-channel transistors 110 and 112. This drives the output of the NOR gate 132 high, thus turning "ON" transistor 130 through NOR gate 132. However, transistor 22 is also turned "ON", since its gate is pulled low, which will pull node 20, the output node, to V_{DD} through transistor 22. The transistor 130 when turned "ON" will pull the gate of transistor 22 to ground through node 126.

A diode connected N-channel transistor 133 has the source/drain thereof connected across transistor 66, with the gate thereof connected to node 68. Transistor 133 will turn "ON" when the output node 44 goes from a high to a low and the buffer is in a hiZ condition due to, for example, an external device pulling the output node 20 to low. Under these conditions, transistor 133 will pull the internal nodes down to reset the buffer. This provides a reset operation whenever the output node 20 goes low in the hiZ state. The purpose for this is to prevent a voltage in excess of the VDD voltage level from being applied across any node or device. For example, if the voltage on the node 68 were higher than Vdd due to an excessively high voltage on the output node at one time followed by a low voltage. If the transistor 133 were not present, then the transistor 66 could have a voltage greater than V_{DD} disposed thereon, thus stressing the gate oxide layer. The transistor 133 pulls this internal node 68 low, insuring that there are no excessively high voltages on any internal nodes. This reset operation also turns "OFF" transistor 130 to raise the node 126 to the threshold voltage of the transistor 128. Note that a P-channel transistor could be utilized in place of the transistor 133 with the gate thereof connected to node 20.

Referring now to Figure 4, there is illustrated a cross-sectional view of a floating N-well. The N-well is typically formed in a P-type substrate by implanting and then driving N-type impurities into the substrate. This will form an N-well 210. Thereafter, a gate electrode 212 separated from the surface of the substrate by a gate oxide layer 214 will be formed in the well and then source/drain regions of P + material will be formed to provide source/drain regions 216 and 218. Additionally, an N + region 218 is formed in N-well 210. This is connected to the node 86, which can be connected by other circuitry to various potentials.

In summary, there has been provided a method for reducing the stress on the output pull-up P-channel transistor in a three-state output buffer. Whenever the output buffer is changed from the hiZ mode to the operating mode and the logic state on the input is such that the output should be pulled high, the output buffer has protection provided in the event that there is already an over voltage on the output. This protection is required in order to minimize the voltage disposed across the oxide of the output pull-up P-channel transistor. When the buffer initially changes from a hiZ state to the operating state, the P-channel transistor is turned "ON" by pulling the gate law. However, the voltage across the gate oxide of the P-channel transistor is limited to the operating voltage of the buffer until the output voltage has fallen to approximately the operating voltage, after which the gate of the P-channel transistor is pulled completely to ground. In this manner, it is insured that a voltage of no greater than the predetermined gate oxide limit will be placed across the gate oxide of the output pull-up P-channel transistor.

Although the preferred embodiment has been described in detail, it should be understood that various changes, substitutions and alterations can be made therein without departing from the spirit and scope of the invention.

## Claims

1. A method for protecting a gate oxide in an output transistor of a three-state output buffer comprising the steps of:
activating the output transistor when the operating mode of the output buffer changes from a high impedance state to a low impedance state and the input logic state is such that the output of the buffer will be pulled high by the output transistor in the low impedance state; and
limiting the maximum voltage across the gate oxide to a first predetermined voltage, such that excessive voltages that exceed the first predetermined voltage on the output will not cause the voltage across the gate oxide to exceed the first predetermined voltage and damage the gate oxide of the output transistor.

2. The method of Claim 1, wherein the step of limiting the maximum voltage comprises limiting the maximum voltage across the gate oxide to a first predetermined voltage that is a supply voltage level of the output buffer.

3. The method of Claim 1, wherein the step of limiting comprises:
conditionally pulling a gate of the output transistor down to a voltage level that is less than the voltage on the output by a value equal to or less than the first predetermined voltage when the operating mode of the output buffer changes from the high impedance state to the low impedance state and the input logic state is such that the output of the buffer will be pulled high by the output transistor in the low impedance state; and
pulling the gate of the output transistor to the low logic level when the voltage at the output is less than or equal to the first predetermined voltage.

4. The method of claim 3, wherein the step of conditionally pulling comprises:
providing a conductive path between the output of the output buffer and the gate of the output transistor when the voltage on the output exceeds the power supply voltage level of the output buffer; and
pulling the gate of the output transistor down to a voltage level lower than the power supply voltage level of the output buffer, when the output buffer input state is low, that results in a voltage difference across the gate oxide of the output transistor of less than or equal to the first predetermined level, wherein the step of providing a conductive path is terminated when the level on the output falls below a second predetermined level above the power supply voltage level of the output buffer.

5. The method of Claim 4, wherein the step of providing the conductive path comprises disposing a shunting transistor between the gate of the output transistor and the output node with the gate of the shunting transistor connected to the power supply voltage, such that, in an over voltage condition, the output transistor does not conduct current from the output to the power supply of the output buffer.

6. The method of Claim 3, further comprising the step of switching between the high impedance state and the low impedance state such that said method comprises the steps of:
providing a two-input NAND gate and driving the gate of the output transistor with the output of the NAND gate and receiving a high input signal on one input thereof and a logic input on the other input thereof, wherein switching from the high impedance to the low impedance state by changing the logic state of the high input signal allows the input logic state on the other input of the NAND gate to control the output of the NAND gate to transition from a high logic state to a low logic state;
the step of conditionally pulling operable to mimic the output level of the NAND gate when it goes to the low logic state to a level above the low logic level of the output buffer; and
the step of pulling the gate of the output transistor to the low logic level operable to cause the output of the NAND gate to go to the low logic level when the input logic state is such that the output of the NAND gate goes low.

7. The method of any preceding claim, further comprising associating at least one peripheral transistor connected between the output of the output buffer and an internal node with the output buffer, such that said internal node can be pulled to a voltage exceeding the first predetermined voltage, and lowering the voltage on the internal node in a reset operation through the peripheral transistor when the voltage on the output of the output buffer goes low in the high impedance state due to an external device driving the output node to the low voltage level.

8. The method of Claim 7, further comprising connecting one of the source/drain terminals of at least one peripheral transistor to the output of the output buffer and either the gate of the at least one peripheral transistor or the other of the source/drain terminals thereof connected to the internal node.

9. The method of Claim 7 or Claim 8, wherein the step of lowering the voltage comprises disposing a diode-connected transistor between the internal node and the output of the output buffer and conducting current through the diode-connected transistor only when the output of the output buffer goes low.

10. The method of any of Claims 7 to 9 further comprising providing protection circuitry for preventing an excess voltage from being disposed across the output transistor, the protection circuitry including the internal node;
activating the protection circuitry when the output of the output buffer goes to an excessively high voltage, wherein the internal node goes to a high voltage level; and wherein the peripheral transistor is a portion of the protection circuitry and the internal node goes low when the output of the output buffer goes low.

11. The method of any preceding claim, wherein the step of protecting the gate oxide comprises protecting the gate oxide in the output of a P-channel pull-up transistor.

12. The method of any preceding claim further comprising:
arranging said output transistor to be operable in a high impedance state to present a high impedance state to receive a logic input and drive the output of the output buffer to a corresponding logic state.

13. A three-state output buffer having an output transistor connected between an output terminal and a power supply node and including a protection circuit for protecting a gate oxide of the output transistor, comprising:
a driving device for actuating the output transistor when the operating mode of the output buffer changes from a high impedance state to a low impedance state and an input logic state is such that the output of the buffer will be pulled high by the output transistor in the low impedance state; and
a limiting device for limiting the maximum voltage across the gate oxide of the output transistor to a first predetermined voltage, such that excessive voltages that exceed the first predetermined voltage on the output terminal will not cause the voltage across the gate oxide of the output.

14. The output buffer of Claim 13, wherein the first predetermined voltage comprises the voltage on a supply node of the output buffer.

15. The output buffer of Claim 13, wherein the limiting device comprises:
a conditional pull-down circuit for conditionally pulling the gate of the output transistor down to a voltage level that is less than the voltage on the output terminal by a value equal to or less than the first predetermined voltage when the operating mode of the output buffer changes from a high impedance state to the low impedance state and the input logic state is such that the output of the buffer will be pulled high by the output transistor in the low impedance state; and
a pull-down device for pulling the gate of the output transistor to the low logic level when the voltage at the output is less than or equal to the first predetermined voltage.

16. The output buffer of Claim 13, further comprising a two-input NAND gate for driving the gate of the output transistor and receiving a high input signal on one input thereof and the logic input on the other input thereof, wherein switching from the high impedance state to the low impedance state allows the input logic state to control the NAND gate output to transition from a high voltage level to a lower voltage level for one logic state of the logic input [AB];
said NAND gate including circuitry for limiting the output to a level above a logic low level for the output buffer when going to a low logic state; and
said pull-down device comprising circuitry for causing the output of said NAND gate when going low to go to a full low logic level of the output buffer.

17. The output buffer of any of Claims 13 to 16, wherein the limiting device comprises:
a selective conductive path disposed between the output of the output buffer and the gate of the output transistor which conducts when the voltage on the output exceeds the power supply voltage level of the output buffer; and
a conditional pull-down device for pulling the gate of the output transistor down to a voltage level lower than the power supply voltage level of the output buffer, when the operating mode of the output buffer changes from a high impedance state to the low impedance state and the input logic state is such that the output of the buffer will be pulled high by the output transistor in the low impedance state, that results in a voltage difference across the gate oxide of the transistor of less than or equal to the first predetermined level, wherein the conductive path is terminated when the level on the output terminal falls below a second predetermined level above the power supply voltage level of the output buffer.

18. The output buffer of Claim 17, wherein the conductive path comprises a shunting transistor disposed between the gate of the output transistor and the output terminal, with the gate of the shunting transistor connected to the power supply node, such that, in an over voltage condition, the output transistor does not conduct current from the output to the power supply node of the output buffer.

19. The output buffer of any of Claims 13 to 18, wherein at least one peripheral transistor is associated with the output buffer and connected between the output terminal of the output buffer and an internal node which said internal node can be pulled to a voltage exceeding the first predetermined voltage, and further comprising reset circuitry for lowering the voltage on said internal node in a reset operation when the voltage on the output terminal of the output buffer goes low in the high impedance state due to an external device driving the output node to the low voltage level.

20. The output buffer of claim 19, wherein said at least one peripheral transistor has one of the source/drain terminals thereof connected to the output of the output terminal and either the gate of said at least one peripheral transistor or the other of the source/drain terminals thereof connected to said internal node.

21. The output buffer of any of Claims 13 to 20, wherein said output transistor comprises a P-channel pull-up transistor.

22. The output buffer of any of Claims 13 to 21, wherein said output transistor is arranged to be operable in a high impedance state to present a high impedance on the output of the output buffer, and in a low impedance state to receive a logic input and drive the output of the output buffer to a corresponding logic state.
